(19) Europäisches Patentamt
European Patent Office
Office européen des brevets

(11) EP 2 639 258 B1

(12) EUROPEAN PATENT SPECIFICATION

(45) Date of publication and mention of the grant of the patent:
**27.04.2016 Bulletin 2016/17**

(51) Int Cl.:
*C08G 77/12* (2006.01) *C08G 77/20* (2006.01)
*C08L 83/10* (2006.01) *C08G 77/00* (2006.01)

(21) Application number: **13158679.4**

(22) Date of filing: **12.03.2013**

(54) **CURABLE SILICONE RESIN COMPOSITION AND OPTOELECTRONIC DEVICE**

HÄRTBARE SILIKON-HARZ-ZUSAMMENSETZUNG UND OPTOELEKTRONISCHE VORRICHTUNG

COMPOSITION DE RÉSINE DE SILICONE DURCISSABLE ET DISPOSITIF OPTOÉLECTRONIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.03.2012 JP 2012055872**
**18.06.2012 JP 2012136714**

(43) Date of publication of application:
**18.09.2013 Bulletin 2013/38**

(73) Proprietor: **Shin-Etsu Chemical Co., Ltd.**
**Chiyoda-ku**
**Tokyo (JP)**

(72) Inventor: **Onai, Satoshi**
**Annaka-shi, Gunma (JP)**

(74) Representative: **Ter Meer Steinmeister & Partner**
**Patentanwälte mbB**
**Nymphenburger Straße 4**
**80335 München (DE)**

(56) References cited:
**EP-A1- 0 971 367** **JP-A- 2007 131 758**
**JP-A- 2010 265 362** **US-A1- 2011 147 955**
**US-A1- 2011 269 918** **US-A1- 2012 056 236**

Remarks:
The file contains technical information submitted after the application was filed and not included in this specification

EP 2 639 258 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### TECHNICAL FIELD

This invention relates to a curable silicone resin composition useful as material for optical devices and optical members, insulating material for electronic devices and electronic parts, coating material, and an optoelectronic semiconductor device encapsulated therewith.

### BACKGROUND ART

Epoxy resins are generally used as the encapsulating material for light-emitting diode (LED) elements. However, since the epoxy resin has a high modulus of elasticity, stress is induced in the epoxy resin during thermal cycling, raising problems that bonding wires are broken by the stress and the epoxy resin is cracked. The stress applied to LED element by the epoxy resin can cause to disrupt the crystal structure of semiconductor, resulting in a drop of emission efficiency. Also, since the LED element releases both light and heat during a long term of operation, a portion of the resin surrounding the element can be discolored to impede extraction of light. Improvements in light resistance and heat resistance are desired.

As the countermeasure to the above problem, Patent Document 1 discloses a silicone-modified organic resin, and Patent Document 2 proposes addition of microparticulate silicone to epoxy resin. However, since these measures use organic component-rich encapsulants, cracks can be formed by ultraviolet light of short wavelength from the optical semiconductor and yellowing can proceed during a long period of operation. Then, the LED device experiences a drop of luminance with the lapse of time.

Further, silicone resins are used as the organic component-free flexible encapsulant, as proposed in Patent Documents 3 to 5, for example. The silicone resin is superior in heat resistance, weather resistance and discoloration resistance to the epoxy resin. The silicone resin is also superior in transparency and optical properties to the epoxy resin and other organic materials. For these reasons, the use of silicone resin with LEDs, especially blue LEDs and white LEDs is recently found in many examples. Since a composition based on a silicone resin having a flexible molecular structure has rubber elasticity over a wide temperature range from low to high temperatures, it is effective for suppressing cracks against thermal shock, ensuring that an LED device remains highly reliable over a long period of time.

On the other hand, the silicone resin material is generally tacky or adhesive and has low material strength because of rubber nature. It is known that these drawbacks are obviated by adding fillers to silicone to enhance material strength and mitigate tack. In Patent Document 6, for example, polyorganosilsesquioxane in nano-particulate polymer form having an average particle size of up to 100 nm is added to a silicone resin composition. The resulting resin composition has high hardness and improved impact resistance while maintaining high transparency. It is thus suited for the encapsulation of optoelectronic semiconductor.

Also, Patent Documents 7 and 8 disclose silicone resin compositions to which is added a silicone-based polymer particles of core/shell structure comprising silicone particles (core) having an average particle size of 0.001 to 1.0 μm coated with an alkoxysilane condensate (shell). The resulting resin compositions have high hardness and improved impact resistance while maintaining high transparency. They are thus suited for the encapsulation of optoelectronic semiconductor devices.

However, silicone fine powder having an average particle size of the submicron order as in the above-cited patent documents is susceptible to discoloration by oxidation at elevated temperatures because of its increased specific surface area. On the other hand, since the LED element which produces a higher luminance as a result of the recent advancement releases a greater amount of heat, it is empirically expected that the surface temperature of the LED element reaches about 150°C during operation. Under the circumstances, when a silicone encapsulant containing silicone submicron particles is used, the encapsulant undergoes fast discoloration due to oxidation of silicone submicron particles themselves. Then the light emitted by the optoelectronic semiconductor element is intercepted by the discolored encapsulant, giving rise to the problem of darkened emission. This means that the LED device has a shortened life or lacks long-term heat resistance.

Further, Patent Documents 9 to 11 disclose silicone resin compositions which are filled with silicone fine particles for the purposes of material strength improvement, light diffusion and color rendering stabilization.

Meanwhile, there is an increasing application of LED devices to outdoor luminaires and automobiles. When an LED device using a silicone encapsulant having high gas permeability is exposed to sulfur oxide gas (commonly referred to as SOx) in the air for a long time, the silver-plated reflector typically included in the LED device as one structural member turns to black silver sulfide, interfering with effective extraction of light emission from the LED device. This necessitates further protection around the LED device, giving negative impacts to brightness extraction efficiency and economy. The techniques of the above-cited patent documents are difficult to prevent silver from sulfiding by SOx. An improvement in this respect is desired.

It would be desirable to have an LED-encapsulating material which is effective by itself for preventing silver sulfiding, resistant to repetitive thermal cycling impacts, unsusceptible to cracks under rigorous thermal cycling, resistant to discoloration upon long-term temperature exposure, and reliable.

Document US 2011/147955 discloses a composition which is similar to the present composition, but in which component (A) has no aryl group.

Citation List

Patent Document 1: JP-A 2007-077252
Patent Document 2: JP-A 2008-192880
Patent Document 3: JP-A H11-001619
Patent Document 4: JP-A 2002-265787
Patent Document 5: JP-A 2004-186168
Patent Document 5: JP-A 2006-321832
Patent Document 7: JP-A 2007-126609
Patent Document 8: JP-A 2008-045039
Patent Document 9: JP-A 2006-339581
Patent Document 10: JP-A 2008-159713
Patent Document 11: JP-A 2011-184625

DISCLOSURE OF INVENTION

An object of the invention is to provide a curable silicone resin composition which in the cured state is highly resistant to repetitive thermal cycling impacts, unsusceptible to cracks under rigorous thermal cycling, resistant to discoloration upon long-term temperature exposure, and gas barrier (capable of preventing permeation of SOx and other gases), and which is useful as material for optical devices and optical members, insulating material for electronic devices and electronic parts, coating material or the like; a cured product of the composition; and an optoelectronic semiconductor device.

Since the prior art encapsulants for LED elements have a likelihood of cracking by thermal shock during electricity conduction and operation of LED as discussed above, there is a need for an encapsulating material which is unsusceptible to cracking and peeling under rigorous thermal cycling.

Notably, an LED-encapsulating composition based on a silicone resin having a flexible molecular structure has rubber physical properties (specifically low modulus of elasticity and high elongation) over a wide temperature range, and is effective for preventing cracks by thermal shock. This material is difficult to provide robust protection to LED elements because it is a tacky (or adhesive) rubber material. When the material is applied to outdoor luminaires and automobiles where strict reliability and a long life are required, drops of properties and economy occur. There is a need for a material which has a high hardness (or high modulus of elasticity), is resistant to cracks by thermal shock, and remains reliable.

As the current supply to an optoelectronic semiconductor element is increased so that the LED device may produce a higher luminance, the heat release and light emission of the element are increased. Then a thermal load which is at least 50°C higher than in the prior art is applied to the material around the light-emitting element. Specifically, the temperature around the light-emitting element reaches about 150°C. The encapsulating material is required to be resistant to thermal discoloration at elevated temperatures.

As described above, there is a need for an LED-encapsulating material which has a high material strength, and is effective for suppressing cracks by thermal shock and resistant to thermal discoloration.

The inventors have found that the outstanding problems are solved by a composition comprising (A-1) an organosilicon compound having at least two aliphatic unsaturated radicals per molecule and optionally, (A-2) an organopolysiloxane of branched or three-dimensional network structure, (B) an organosilicon compound having at least two silicon-bonded hydrogen atoms per molecule and free of aliphatic unsaturation, (C) a hydrosilylation catalyst, and (D) silicone powder having an average particle size of 0.5 to 100 $\mu$m. This addition-curable silicone resin composition is suitable as the LED-encapsulating material.

The curable silicone resin composition cures into a product which is highly resistant to repetitive thermal impacts, unsusceptible to cracks under rigorous thermal cycling, and resistant to discoloration upon long-term temperature exposure.

In one aspect, the invention provides a curable silicone resin composition comprising

(A) the following component (A-1) or a mixture of components (A-1) and (A-2):

(A-1) a compound having at least two aliphatic unsaturated radicals per molecule, represented by the formula (1):

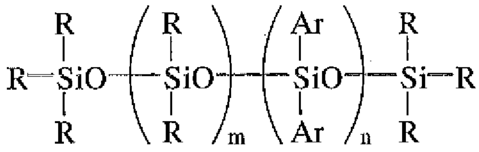

(1)

wherein R is each independently a substituted or unsubstituted monovalent hydrocarbon radical, Ar is each independently an aryl radical optionally containing a heteroatom, m is 0 or an integer of at least 1, and n is an integer of at least 1,

(A-2) an organopolysiloxane of branched or three-dimensional network structure represented by the average compositional formula (2):

$$R'_p(C_6H_5)_qSiO_{(4-p-q)/2} \qquad (2)$$

wherein R' is each independently a substituted or unsubstituted monovalent hydrocarbon radical, alkoxy radical or hydroxyl radical, 0.1 to 80 mol% of all silicon-bonded organic radicals being alkenyl, p and q are positive numbers meeting the range: $1 \leq p+q < 2$ and $0.20 \leq q/(p+q) \leq 0.95$,

(B) an organosilicon compound having at least two silicon-bonded hydrogen atoms per molecule and free of aliphatic unsaturation, in a sufficient amount for the composition to cure in the presence of a hydrosilylation catalyst,
(C) a platinum group metal based hydrosilylation catalyst, and
(D) silicone powder having an average particle size of 0.5 to 100 μm, in an amount of 0.1 to 500 parts by weight per 100 parts by weight of components (A) and (B) combined. A sub-composition composed essentially of components (A), (B) and (C), when cured, has an oxygen permeability of up to 1,000 $cm^3/m$ /24h/101325 Pa.

Preferably, in formula (1), Ar is phenyl, and n is an integer of 1 to 100.

In a preferred embodiment, component (B) is an organohydrogenpolysiloxane having the average compositional formula (3):

$$R''_aH_bSiO_{(4-a-b)/2} \qquad (3)$$

wherein R" is each independently a silicon-bonded, substituted or unsubstituted monovalent hydrocarbon radical other than an aliphatic unsaturated radical, a and b are positive numbers meeting the range: $0.7 \leq a \leq 2.1$, $0.001 \leq b \leq 1.0$, and $0.8 \leq a+b \leq 3.0$.

In a preferred embodiment, component (D) consists of particles of a polyorganosilsesquioxane resin or silicone particles covered partially or entirely on their surface with a polyorganosilsesquioxane resin.

The composition is typically used for the encapsulation of optoelectronic semiconductor.

In another aspect, the invention provides a cured product obtained by curing the curable silicone resin composition defined above.

In a further aspect, the invention provides an optoelectronic semiconductor device obtained by encapsulating an optoelectronic semiconductor element with the curable silicone resin composition defined above and heat curing the composition.

## ADVANTAGEOUS EFFECTS OF INVENTION

The curable silicone resin composition cures into a product which is highly resistant to repetitive thermal impacts, unsusceptible to cracks under rigorous thermal cycling, and resistant to discoloration upon long-term temperature exposure, and prevents sulfur oxide gas from being transmitted thereby. The composition is advantageously applied to those optoelectronic semiconductor devices used in a more rigorous environment.

## BRIED DESCRIPTION OF DRAWING

FIG. 1 is a schematic cross-sectional view of an optoelectronic semiconductor device to which the curable silicone resin composition is applied.

DESCRIPTION OF PREFERRED EMBODIMENTS

The curable silicone resin composition of the invention is useful as an optical part-coating material, typically LED-encapsulating material. The composition comprises components (A) to (D), which are described below in detail.

Component A

Component (A) is component (A-1) or a mixture of components (A-1) and (A-2). Component (A-1) is a compound having at least two aliphatic unsaturated radicals per molecule, represented by the formula (1):

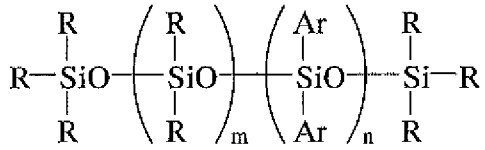

(1)

wherein R is each independently a substituted or unsubstituted monovalent hydrocarbon radical, Ar is each independently an aryl radical optionally containing a heteroatom, m is 0 or an integer of at least 1, and n is an integer of at least 1. Differently stated, component (A-1) is a linear diorganopolysiloxane comprising recurring diarylsiloxane units as the backbone. Component (A-1) may be an organopolysiloxane alone or a mixture of two or more organopolysiloxanes having different molecular weights and/or silicon-bonded organic groups of different type.

In formula (1), examples of the aryl radical represented by Ar include aromatic hydrocarbon radicals such as phenyl and naphthyl, and aromatic hydrocarbon radicals containing a heteroatom (e.g., O, S or N) such as furanyl. The aryl radical may have a substituent(s) such as halogen atom (e.g., chloro, bromo or fluoro). Preferably Ar is an unsubstituted aromatic hydrocarbon radical, most preferably phenyl.

Examples of the substituted or unsubstituted monovalent hydrocarbon radical represented by R in formula (1) include aliphatic unsaturated radicals (to be described later) and monovalent hydrocarbon radicals other than the aliphatic unsaturated radicals, for example, alkyl radicals of 1 to 6 carbon atoms such as methyl, ethyl, propyl, isopropyl, butyl, isobutyl, sec-butyl, and tert-butyl; haloalkyl radicals of 1 to 4 carbon atoms such as chloromethyl and 3,3,3-trifluoropropyl; and aryl radicals of 6 to 10 carbon atoms such as phenyl and tolyl. Of the monovalent hydrocarbon radicals other than the aliphatic.unsaturated radicals, preference is given to alkyl radicals of 1 to 6 carbon atoms and phenyl, with methyl being most preferred.

The aliphatic unsaturated radical represented by R in formula (1) is not particularly limited as long as it maintains the composition in a stable uncured state prior to the start of addition reaction and it permits the composition to readily cure after the start of addition reaction. Exemplary are ethylenically unsaturated radicals and acetylenically unsaturated radicals. The aliphatic unsaturated radical may be of one type or a mixture of two or more types. At least two aliphatic unsaturated radicals must be included per molecule, while they are preferably positioned at both ends.

As used herein, the term "ethylenically unsaturated radical" refers to an organic radical which contains a carbon-carbon double bond and optionally, a heteroatom such as oxygen or nitrogen. Examples include alkenyl radicals of 2 to 20 carbon atoms, preferably 2 to 10 carbon atoms such as vinyl, allyl, 5-hexenyl, propenyl and butenyl; alkadienyl radicals of 4 to 10 carbon atoms such as 1,3-butadienyl; combinations of the alkenyl radicals with carbonyloxy such as acryloyloxy ($-O(O)CCH=CH_2$) and methacryloyloxy ($-O(O)CC(CH_3)=CH_2$); and combinations of the alkenyl radicals with carbonylamino such as acrylamide ($-NH(O)CCH=CH_2$).

As used herein, the term "acetylenically unsaturated radical" refers to an organic radical which contains a carbon-carbon triple bond and optionally, a heteroatom such as oxygen or nitrogen. Examples include alkynyl radicals of 2 to 20 carbon atoms, preferably 2 to 10 carbon atoms such as ethynyl and propargyl; and combinations of the alkynyl radicals with carbonyloxy such as ethynylcarbonyloxy ($-O(O)CC\equiv CH$).

It is preferred from the standpoints of productivity and cost in the preparation of reactants for component (A-1), reactivity of component (A-1) and the like that the aliphatic unsaturated radical be any of the alkenyl radicals, more preferably vinyl, allyl or 5-hexenyl, and most preferably vinyl.

In component (A-1), n indicative of a degree of polymerization of diarylsiloxane units is an integer of at least 1, preferably 1 to 100, more preferably 1 to 20, and even more preferably 2 to 10; m is an integer of 0, 1 or more, preferably an integer of 0 to 100, and more preferably 0 to 20.

Component (A-1) may be prepared, for example, from a difunctional silane such as dichlorodiphenylsilane or dialkoxydiphenylsilane, by effecting hydrolysis and condensation and subsequently or simultaneously blocking at the end with an endcapping agent containing an aliphatic unsaturated radical.

In the curable silicone resin composition, component (A-2) is optionally added to component (A-1) for the purpose of acquiring cured hardness.

Component (A-2) is an organopolysiloxane of branched or three-dimensional network structure represented by the average compositional formula (2):

$$R'_p(C_6H_5)_qSiO_{(4-p-q)/2} \qquad (2)$$

wherein R' is each independently a substituted or unsubstituted monovalent hydrocarbon radical, alkoxy radical or hydroxyl radical, 0.1 to 80 mol% of all silicon-bonded organic radicals being alkenyl, p and q are positive numbers meeting the range: $1 \leq p+q < 2$ and $0.20 \leq q/(p+q) \leq 0.95$. Component (A-2) may be an organopolysiloxane alone or a mixture of two or more.

As understood from the range: $1 \leq p+q < 2$ in average compositional formula (2), the organopolysiloxane has a branched or three-dimensional network structure containing units of one or more type selected from $R'SiO_{3/2}$ units (wherein R' is as defined above), $(C_6H_5)SiO_{3/2}$ units, and $SiO_2$ units, in the molecule.

In formula (2), $C_5H_5$ stands for phenyl. R' is each independently a substituted or unsubstituted monovalent hydrocarbon radical (exclusive of phenyl), alkoxy radical or hydroxyl radical, preferably a substituted or unsubstituted monovalent hydrocarbon radical of 1 to 20 carbon atoms, more preferably 1 to 10 carbon atoms, alkoxy radical or hydroxyl radical. Suitable hydrocarbon radicals include alkyl radicals such as methyl, ethyl, propyl, butyl, pentyl, hexyl, cyclohexyl and heptyl; aryl radicals (exclusive of phenyl) such as tolyl, xylyl and naphthyl; aralkyl radicals such as benzyl and phenethyl; unsaturated hydrocarbon radicals, for example, alkenyl radicals such as vinyl, allyl, butenyl, pentenyl, hexenyl, and heptenyl; and haloalkyl radicals such as chloromethyl, 3-chloropropyl and 3,3,3-trifluoropropyl. Suitable alkoxy radicals include unsubstituted alkoxy radicals such as methoxy, ethoxy, propoxy, and phenoxy, and alkoxy-substituted alkoxy radicals such as methoxyethoxy and ethoxyethoxy.

In formula (2), alkenyl should account for 0.1 to 80 mol%, preferably 0.5 to 50 mol% of all silicon-bonded organic radicals. If the alkenyl content is less than 0.1 mol%, the resulting silicone resin fails to acquire the requisite hardness. If the alkenyl content exceeds 80 mol%, the resulting silicone resin becomes brittle because of too many crosslinking sites. Of the alkenyl radicals, vinyl is most preferred.

The subscripts p and q are positive numbers meeting the range: $1 \leq p+q < 2$, preferably $1.2 \leq p+q < 1.9$, and $0.20 \leq q/(p+q) \leq 0.95$, preferably $0.25 \leq q/(p+q) \leq 0.90$. If p+q is less than 1 or equal to or more than 2, the requisite hardness and strength are not acquired. If the phenyl content is less than the range, the resulting silicone resin fails to acquire the requisite hardness and strength. An excessive phenyl content adversely affects heat resistance.

Examples of the organopolysiloxane (A-2) include, but are not limited to,

$$(PhSiO_{3/2})_{0.55}\,[(CH_2{=}CH)Me_2SiO_{1/2}]0.2(Me2SiO)_{0.25}$$

and

$$(PhSiO_{3/2})_{0\cdot 75}[(CH_2{=}CH)Me_2SiO_{1/2}]_{0\cdot 25}$$

wherein Ph stands for phenyl and Me stands for methyl.

Component (A-2) is added in such an amount that the cured resin composition may have the desired hardness, typically in an amount of 0 to 500 parts by weight per 100 parts by weight of component (A-1). When used, component (A-2) is preferably added in an amount of 20 to 300 parts by weight per 100 parts by weight of component (A-1).

<u>Component B</u>

Component (B) is an organosilicon compound having at least two silicon-bonded hydrogen atoms (i.e., SiH radicals) per molecule and free of aliphatic unsaturation. It may also be referred to as SiH-containing organosilicon compound. It serves as a crosslinker via hydrosilylation or addition reaction with component (A). Component (B) may be an organosilicon compound alone or a mixture of two or more. Any well-known organosilicon compound may be used as component (B) as long as it has at least two SiH radicals per molecule. Examples include organohydrogenpolysiloxanes, organohydrogensilanes, organic oligomers and organic polymers having at least two SiH radicals per molecule. Inter alia, organohydrogenpolysiloxanes having at least two SiH radicals per molecule are preferred.

In component (B), the silicon-bonded organic radicals include unsubstituted monovalent hydrocarbon radicals free of aliphatic unsaturation, and monovalent hydrocarbon radicals substituted with halogen atoms (e.g., chloro, bromo and fluoro), epoxy-containing radicals (e.g., epoxy, glycidyl and glycidoxy), alkoxy radicals (e.g., methoxy, ethoxy, propoxy and butoxy) or the like. Suitable monovalent hydrocarbon radicals include those exemplified as the substituted or unsubstituted monovalent hydrocarbon radicals of R in formula (1) representative of component (A-1), for example, alkyl radicals of 1 to 6 carbon atoms, haloalkyl radicals of 1 to 4 carbon atoms, and aryl radicals of 6 to 10 carbon atoms. The preferred organic radicals include alkyl radicals of 1 to 6 carbon atoms and aryl radicals of 6 to 10 carbon atoms, with

methyl or phenyl being most preferred. The monovalent hydrocarbon radical substituted with an epoxy-containing radical and/or alkoxy radical is effective for imparting adhesion to the cured resin composition.

As long as component (B) is an organohydrogenpolysiloxane having at least two SiH radicals per molecule, the molecular structure of organohydrogenpolysiloxane is not particularly limited. Any of currently available organohydrogenpolysiloxanes of linear, cyclic, branched and three-dimensional network (or resinous) structures may be used.

The organohydrogenpolysiloxane has at least 2 (specifically 2 to about 300), preferably at least 3 (specifically 3 to about 200, more specifically 4 to about 100) SiH radicals per molecule. Where the organohydrogenpolysiloxane is of linear or branched structure, the SiH radicals may be positioned at either one or both of the terminal and non-terminal positions of the molecular chain.

In the organohydrogenpolysiloxane, the number of silicon atoms (i.e., degree of polymerization) is preferably about 2 to about 1,000, more preferably about 3 to about 200, and even more preferably about 4 to about 100 per molecule. The organohydrogenpolysiloxane is preferably liquid at 25°C and specifically has a viscosity of 1 to 1,000 mPa-s, more preferably 10 to 100 mPa-s at 25°C as measured by a rotational viscometer.

The organohydrogenpolysiloxane used herein preferably has the average compositional formula (3), for example.

$$R''_aH_bSiO_{(4-a-b)/2} \qquad (3)$$

Herein R" is each independently a silicon-bonded, substituted or unsubstituted monovalent hydrocarbon radical other than an aliphatic unsaturated radical, a and b are positive numbers meeting the range: $0.7 \leq a \leq 2.1$, $0.001 \leq b \leq 1.0$, and $0.8 \leq a+b \leq 3.0$, preferably $1.0 \leq a \leq 2.0$, $0.01 \leq b \leq 1.0$, and $1..5 \leq a+b \leq 2.5$.

In formula (3), suitable monovalent hydrocarbon radicals (exclusive of the aforementioned aliphatic unsaturated radical) of R" include those exemplified as the substituted or unsubstituted monovalent hydrocarbon radicals of R in formula (1) representative of component (A-1), for example, alkyl radicals of 1 to 6 carbon atoms, haloalkyl radicals of 1 to 4 carbon atoms, and aryl radicals of 6 to 10 carbon atoms. R" is preferably selected from alkyl radicals of 1 to 6 carbon atoms and aryl radicals of 6 to 10 carbon atoms, with methyl or phenyl being most preferred.

Examples of the organohydrogenpolysiloxane having average compositional formula (3) include cyclic compounds containing at least 4 organohydrogensiloxane units of the formula: R"HSiO, compounds of the formula: $R''_3SiO(HR''SiO)_cSiR''_3$, compounds of the formula: $HR''_2SiO(HR''SiO)_cSiR''_2H$, and compounds of the formula: $HR''_2SiO(HR''SiO)_c(R''_2SiO)_dSiR''_2H$ wherein R" is as defined above, c and d are numbers of at least 1.

Alternatively, the organohydrogenpolysiloxane having average compositional formula (3) may comprise siloxane units of the formula: $HSiO_{1.5}$, siloxane units of the formula: R"HSiO, and/or siloxane units of the formula: $R''_2HSiO_{0.5}$ wherein R" is as defined above. The organohydrogenpolysiloxane may also comprise monoorganosiloxane units, diorganosiloxane units, triorganosiloxane units and/or $SiO_{4/2}$ units, which are free of SiH radical.

In the organohydrogenpolysiloxane having average compositional formula (3), methylhydrogensiloxane units preferably account for 30 to 100 mol% of all organosiloxane units.

Examples of the organohydrogenpolysiloxane having at least two SiH radicals (B) include

1,1,3,3-tetramethyldisiloxane,
1,3,5,7-tetramethylcyclotetrasiloxane,
tris(hydrogendimethylsiloxy)methylsilane,
tris(hydrogendimethylsiloxy)phenylsilane,
methylhydrogencyclopolysiloxane,
methylhydrogensiloxane/dimethylsiloxane cyclic copolymers,
trimethylsiloxy-endcapped methylhydrogenpolysiloxane,
trimethylsiloxy-endcapped dimethylsiloxane/methylhydrogensiloxane copolymers,
trimethylsiloxy-endcapped diphenylsiloxane/methylhydrogensiloxane copolymers,
trimethylsiloxy-endcapped methylphenylsiloxane/methylhydrogensiloxane copolymers,
trimethylsiloxy-endcapped dimethylsiloxane/methylhydrogensiloxane/methylphenylsiloxane copolymers,
trimethylsiloxy-endcapped dimethylsiloxane/methylhydrogensiloxane/diphenylsiloxane copolymers,
dimethylhydrogensiloxy-endcapped methylhydrogenpolysiloxane,
dimethylhydrogensiloxy-endcapped dimethylpolysiloxane,
dimethylhydrogensiloxy-endcapped dimethylsiloxane/methylhydrogensiloxane copolymers,
dimethylhydrogensiloxy-endcapped dimethylsiloxane/methylphenylsiloxane copolymers,
dimethylhydrogensiloxy-endcapped dimethylsiloxane/diphenylsiloxane copolymers,
dimethylhydrogensiloxy-endcapped methylphenylpolysiloxane,
dimethylhydrogensiloxy-endcapped diphenylpolysiloxane,
dimethylhydrogensiloxy-endcapped diphenylsiloxane/methylhydrogensiloxane copolymers, and

substituted forms of the foregoing organohydrogenpolysiloxanes in which some or all methyl radicals are substituted by other alkyl radicals such as ethyl or propyl,
organosiloxane copolymers consisting of siloxane units of $R''_3SiO_{0.5}$,
siloxane units of $R''_2HSiO_{0.5}$, and
siloxane units of $SiO_2$,
organosiloxane copolymers consisting of siloxane units of $R''_2HSiO_{0.5}$ and siloxane units of $SiO_2$,
organosiloxane copolymers consisting of siloxane units of R"HSiO, and
siloxane units of R" $SiO_{1.5}$ and/or siloxane units of $HSiO_{1.5}$. and mixtures of two or more of the foregoing organopolysiloxanes.
Herein, R" is as defined above. It is noted that the term "endcapped" means that a siloxane is capped at both ends of the molecular chain with the referenced radicals, unless otherwise stated.

Component (B) is used in a sufficient amount for the composition to cure in the presence of a hydrosilylation catalyst, typically in such an amount that the molar ratio of SiH radicals in component (B) to aliphatic unsaturated radicals in component (A) may range from 0.2/1 to 5/1, preferably from 0.5/1 to 2/1.

Component C

Component (C) is a platinum group metal based hydrosilylation catalyst. It may be any of catalysts which promote hydrosilylation or addition reaction between silicon-bonded aliphatic unsaturated radicals in component (A) and SiH radicals in component (B). Component (C) may be a catalyst alone or a mixture of two or more. Suitable catalysts include platinum group metals such as platinum, palladium and rhodium, chloroplatinic acid, alcohol-modified chloroplatinic acid, coordinate compounds of chloroplatinic acid with olefin, vinylsiloxane or acetylene compounds, platinum group metal compounds such as tetrakis(triphenylphosphine)palladium and chlorotris(triphenylphosphine)rhodium. Inter alia, platinum compounds are preferred. The catalyst may be used in a catalytic amount, which is typically 0.1 to 1,000 ppm, more preferably 1 to 500 ppm of platinum group metal based on the total weight of components (A) and (B).

Preferably, when a sub-composition composed essentially of components (A) to (C) as defined above is heat cured, the cured product has an oxygen permeability of up to 1,000 $cm^3/m^2/24h/atm$. As long as the oxygen permeability of the cured composition is up to 1,000 $cm^3/m^2/24h/atm$, the invention's effect of inhibiting permeation of sulfur oxide and other gases is advantageously exerted. More preferably the oxygen permeability is up to 500 $cm^3/m^2/24h/atm$. With an oxygen permeability in excess of 1,000 $cm^3/m^2/24h/atm$, there is a risk that when an LED package constructed by filling a cavity around a partially silver-plated LED device with an encapsulating resin composition and curing the composition is subjected to a sulfur exposure test, sulfur can permeate through the encapsulating resin to promote sulfiding of plated silver so that silver turns to black silver sulfide. As a result, the luminance of the LED package may be reduced. The lower limit of oxygen permeability is typically at least 0 $cm^3/m^2/24h/atm$, though not critical. The measurement of oxygen permeability will be described later.

Component D

The curable silicone resin composition is characterized by comprising (D) silicone powder in addition to components (A) to (C) defined above. The addition of silicone powder as component (D) offers one advantage of improvement in mechanical properties. Since the silicone powder has low elasticity, it functions as a stress releaser to heat shocks repeatedly applied in turning on and off the light-emitting element. Accordingly, the encapsulating resin loaded with silicone powder is highly resistant to thermal shock and unsusceptible to cracks under rigorous thermal cycling conditions. In addition, the silicone powder can clear the problems of the resin composition that it has tack or adhesion inherent to rubber material and is difficult to provide robust protection to the LED element because of rubber nature. That is, the silicone powder serves to mitigate tack and stiffen the cured product.

A second advantage is an improvement in discoloration resistance. The silicone powder is known to experience least discoloration in a high-temperature environment. Thus adding silicone powder to the encapsulating resin is effective for suppressing discoloration of the resin when hot. Also, since the silicone powder is not light absorptive, it is devoid of gradual blackening upon exposure to UV light from the light-emitting element, as often found with other organic resin powders. Thus adding silicone powder to the encapsulating resin is effective for suppressing discoloration of the resin in a high-temperature environment. Then the resin can maintain transparency upon long-term exposure to UV light, yielding an optoelectronic semiconductor device having a longer lifetime.

Examples of the silicone powder include silicone resin particles, typically fine particles of polyorganosilsesquioxane, for example, those described in JP-B S40-16917, JP-A S54-72300, S60-13813, H03-244636, and H04-88023; composite silicone particles of the structure in which silicone rubber particles are surface covered with fine particles of polyorganosilsesquioxane resin, for example, those described in JP-A H07-196815. The silicone powder may be used

alone or in admixture of two or more. The silicone powder may be prepared by any well-known methods while any commercially available silicone powder may be used.

The silicone powder should have an average particle size in the range of 0.5 to 100 μm, preferably 1 to 15 μm. Particles with an average particle size of less than 0.5 μm will agglomerate together when dispersed in the resin composition, inviting a drop of strength of the cured resin composition. Since such submicron particles have an increased specific surface area, they undergo discoloration by oxidation at elevated temperatures, indicating a lowering of thermal discoloration resistance. An average particle size in excess of the range is undesirable because the step of uniformly dispensing and dispersing such particles in the resin composition is interfered, specifically giving rise to problems of stringing and dispensing nozzle clogging.

It is noted that the average particle size is determined as cumulative weight average value $D_{50}$ (or median diameter) upon particle size distribution measurement by the laser light diffraction method.

The silicone powder is used in an amount of 0.1 to 500 parts, preferably 1 to 100 parts by weight per 100 parts by weight of components (A) and (B) combined. Outside the range, a lower content of silicone powder fails to provide the cured resin composition with desired properties including thermal shock resistance, least thermal discoloration and gas barrier whereas a higher content provides the resin composition with a high viscosity which is industrially undesirable because the working (including casting and curing) of the composition is adversely affected.

Silicone powders are commercially available. Exemplary silicone resin powders include KMP590, KMP701, X-52-854, and X-52-1621, and exemplary composite silicone powders include KMP600, KMP601, KMP602, KMP605, and X-52-7030, all commercially available from Shin-Etsu Chemical Co., Ltd., but are not limited thereto.

<u>Other components</u>

In addition to components (A) to (D) defined above, other components may be optionally compounded in the composition of the invention insofar as the objects of the invention are not impeded. Optional components are described below. Each component may be a single compound or a mixture of two or more compounds.

-- Aliphatic unsaturation-bearing compound other than component (A)

Besides component (A), an aliphatic unsaturation-bearing compound capable of addition reaction to component (B) may be compounded in the composition. The aliphatic unsaturation-bearing compound other than component (A) is preferably one that participates in formation of a cured product, typically an organopolysiloxane other than the organopolysiloxane having at least two aliphatic unsaturated radicals per molecule (A-1). Its molecular structure may be linear, cyclic, branched or three-dimensional network, for example.

In the composition, an aliphatic unsaturation-bearing organic compound other than the aforementioned organopolysiloxane may be compounded. Suitable aliphatic unsaturation-bearing compounds include monomers such as butadiene and diacrylates derived from polyfunctional alcohols; polyolefins such as polyethylene, polypropylene, and copolymers of styrene with other ethylenically unsaturated compounds (e.g., acrylonitrile and butadiene); oligomers and polymers derived from functionality-substituted organic compounds such as esters of acrylic acid, methacrylic acid and maleic acid. The aliphatic unsaturation-bearing compound other than component (A) may be either liquid or solid at room temperature.

--Addition reaction inhibitor

In the composition, an addition reaction inhibitor may be added for providing a pot life. The addition reaction inhibitor is not particularly limited as long as it is effective for suppressing the cure promotion of the hydrosilylation catalyst (C). Any of well-known inhibitors may be used. Exemplary inhibitors include phosphorus-containing compounds such as triphenylphosphine, nitrogen-containing compounds such as tributylamine, tetramethylethylenediamine, and benzotriazole, sulfur-containing compounds, acetylene compounds such as acetylene alcohols, e.g., 1-ethynylcyclohexanol and 3,5-dimethyl-1-hexyn-3-ol, compounds having at least two alkenyl radicals, hydroperoxy compounds, and maleic acid derivatives.

The degree of cure suppression that the addition reaction inhibitor exerts depends on its chemical structure. Thus, the amount of inhibitor added is preferably adjusted to optimum for a particular addition reaction inhibitor used. When an optimum amount of the addition reaction inhibitor is added, the composition has a good balance of long-term shelf stability at room temperature and heat curability.

--Silane coupling agent

A tackifier may be added to the composition for improving its adhesion. Typical tackifiers are silane coupling

agents and hydrolytic condensates thereof. Suitable silane coupling agents include epoxy-containing silane coupling agents (e.g., γ-glycidoxypropyltrimethoxysilane), (meth)acrylic silane coupling agents, isocyanate-containing silane coupling agents, isocyanurate-containing silane coupling agents, amino-containing silane coupling agents, and mercapto-containing silane coupling agents. The silane coupling agent is preferably added in an amount of 0.1 to 20 parts, more preferably 0.3 to 10 parts by weight per 100 parts by weight of components (A) and (B) combined.

--Other optional components

Also, any well-known antioxidants such as 2,6-di-t-butyl-4-methylphenol may be added to the composition for the purpose of preventing the cured composition from coloration and oxidative degradation. Photo-stabilizers such as hindered amine stabilizers may be added to the composition for the purpose of imparting resistance to photo-degradation. Inorganic fillers such as fumed silica and nano-size alumina may be added to the composition for the purposes of improving strength and preventing particle settlement as long as the transparency of the cured composition is not affected. If desired, dyes, pigments, flame retardants or the like may be added to the composition.

Cured product

The silicone composition may be cured under well-known conditions by any standard methods. Specifically, the composition may be cured by heating at a temperature of 80 to 200°C, preferably 100 to 160°C. The heating time may be about 0.5 minute to about 5 hours, preferably about 1 minute to about 3 hours. A relatively long cure time is preferred where an accuracy is required as in the case of LED encapsulation. The form of the cured composition is not particularly limited. The cured product may be of gel, elastomer or resin form, for example.

Optoelectronic device encapsulant

Like cured products of conventional addition-curable silicone compositions, the cured product of the composition is improved in heat resistance, freeze resistance and electrical insulation. The composition is used as encapsulant for optoelectronic devices including, for example, LED, semiconductor laser, photo-diodes, photo-transistors, solar cells, and CCD. The optoelectronic package may be obtained by coating an optoelectronic element with the composition (i.e., encapsulant), and curing the composition by any standard methods under well-known conditions, specifically under the above-mentioned conditions.

EXAMPLE

Examples of the invention are given below by way of illustration and not by way of limitation. In Examples, all parts are by weight. A silicone oil or silicone resin is represented by an average compositional formula wherein symbols denote the following units. The molar amount associated with a silicone oil or silicone resin is the molar amount of vinyl or SiH radicals contained in each component.

$M^H$: $(CH_3)_2HSiO_{1/2}$
M: $(CH_3)_3SiO_{1/2}$
$M^{Vi}$: $(CH_2{=}CH)\ (CH_3)_2SiO_{1/2}$
$M^{Vi3}$: $(CH_2CH)_3SiO_{1/2}$
$D^H$ : $(CH_3)HSiO_{2/2}$
$D^{ph}$: $(C_6H_5)_2SiO_{2/2}$
D: $(CH_3)_2SiO_{2/2}$
$D^{Vi}$: $(CH2{=}CH)(CH_3)\ SiO_{2/2}$
$T^{ph}$: $(C_6H_5)SiO_{3/2}$
Q: $SiO_{4/2}$

Formulation Example 1

A silicone sub-composition #1 was prepared by thoroughly milling the following components:

100 parts of a silicone oil of average compositional formula:

$m^{Vi}{}_2D^{Ph}{}_{2.8}$ as component (A),
51.3 parts of methylhydrogensiloxane of average compositional formula: $M^HD^H{}_2D^{Ph}{}_2M^H$ as component (B),

0.06 part of a toluene solution of chloroplatinic acid/ 1,3-divinyltetramethyldisiloxane complex (1 wt% Pt) as component (C),
0.05 part of ethynylcyclohexanol, and
3 parts of γ-glycidoxypropyltrimethoxysilane.

Sub-composition #1 as cured was measured to have an oxygen permeability of 210 $cm^3/m^2/24h/atm$.

Formulation Example 2

A silicone sub-composition #2 was prepared by thoroughly milling the following components:

23 parts of a silicone oil of average compositional formula:

$MD_{3.4}D^{Vi}_{6.5}D^{Ph}_{8.6}M$ and 80 parts of a silicone oil of average compositional formula: $M^{Vi}_2D^{Ph}_{2.8}$ as component (A),
30 parts of methylhydrogensiloxane of average compositional formula: $M^HD^H_2D^{Ph}_2M^H$ as component (B),
0.06 part of a toluene solution of chloroplatinic acid/ 1,3-divinyltetramethyldisiloxane complex (1 wt% Pt) as component (C),
0.05 part of ethynylcyclohexanol, and
3 parts of γ-glycidoxypropyltrimethoxysilane.

Sub-composition #2 as cured was measured to have an oxygen permeability of 400 $cm^3/m^2/24h/atm$.

Formulation Example 3

A silicone sub-composition #3 was prepared by thoroughly milling the following components:

a mixture of 65 parts of a silicone resin consisting of M, $M^{Vi}$, and Q units wherein a molar ratio of M units to $M^{Vi}$ units is 6.25, and a molar ratio of the sum of M units and $M^{Vi}$ units to Q units is 0.8, and 35 parts of a silicone oil of average compositional formula: $M^{Vi3}D_{298}M^{Vi3}$ (which mixture is a viscous liquid at room temperature) as component (A'),
8 parts of methylhydrogensiloxane of average compositional formula: $MD^H_{80}M$ as component (B),
0.06 part of a toluene solution of chloroplatinic acid/ 1,3-divinyltetramethyldisiloxane complex (1 wt% Pt) as component (C),
0.05 part of ethynylcyclohexanol, and
3 parts of γ-glycidoxypropyltrimethoxysilane.

Sub-composition #3 as cured was measured to have an oxygen permeability of 20,000 $cm^3/m^2/24h/atm$.

Formulation Example 4

A silicone sub-composition #4 was prepared by thoroughly milling the following components:

a mixture of (A-1) 31 parts of a silicone oil of average compositional formula: $M^{Vi}_2D^{Ph}_{2.8}$ and (A-2) 59 parts of branched chain organopolysiloxane of formula: $T^{Ph}_{0.75}M^{Vi}_{0.25}$ (solid at 25° C, silicon-bonded vinyl content = 20 mol% and silicon-bonded phenyl content = 50 mol% based on all silicon-bonded organic radicals, weight average molecular weight = 1600 versus polystyrene standards) as component (A),
6.4 parts of methylhydrogensiloxane of average compositional formula: $M^HD^H_2D^{Ph}_2M^H$ as component (B),
0.06 part of a toluene solution of chloroplatinic acid/ 1,3-divinyltetramethyldisiloxane complex (1 wt% Pt) as component (C),
0.05 part of ethynylcyclohexanol, and
3 parts of γ-glycidoxypropyltrimethoxysilane.

Sub-composition #4 as cured was measured to have an oxygen permeability of 250 $cm^3/m^2/24h/atm$.

Example 1

A composition (a) was prepared by mixing 100 parts of Sub-composition #1 with 10 parts of composite silicone powder having an average particle size of 5 μm (KMP-600 by Shin-Etsu Chemical Co., Ltd.) until uniform.

Example 2

A composition (b) was prepared by mixing 100 parts of Sub-composition #1 with 10 parts of silicone resin powder having an average particle size of 5 μm (X-52-1621 by Shin-Etsu Chemical Co., Ltd.) until uniform.

Example 3

A composition (c) was prepared by mixing 100 parts of Sub-composition #2 with 5 parts of composite silicone powder having an average particle size of 0.8 μm (X-52-7030 by Shin-Etsu Chemical Co., Ltd.) until uniform.

Example 4

A composition (d) was prepared by mixing 100 parts of Sub-composition #2 with 5 parts of silicone resin powder having an average particle size of 0.8 μm (X-52-854 by Shin-Etsu Chemical Co., Ltd.) until uniform.

Example 5

A composition (e) was prepared by mixing 100 parts of Sub-composition #4 with 5 parts of silicone resin powder having an average particle size of 0.8 μm (X-52-854 by Shin-Etsu Chemical Co., Ltd.) until uniform.

Comparative Example 1

Sub-composition #1 was used as composition (f) without adding silicone powder.

Comparative Example 2

A composition (g) was prepared by mixing 100 parts of Sub-composition #1 with 10 parts of silicone resin powder (obtained by cutting off a coarse fraction of X-52-854 by Shin-Etsu Chemical Co., Ltd. so that the remaining fraction had an average particle size of 0.4 μm) until uniform.

Comparative Example 3

Sub-composition #3 was used as composition (h) without adding silicone powder.

Comparative Example 4

A composition (i) was prepared by mixing 100 parts of Sub-composition #1 with 600 parts of silicone resin powder having an average particle size of 5 μm (X-52-1621 by Shin-Etsu Chemical Co., Ltd.) until uniform.

Silicone compositions (a) to (i) prepared in Examples and Comparative Examples were evaluated by the following methods.

[Evaluation methods]

Optoelectronic semiconductor package

The optoelectronic semiconductor element used was an LED chip having a light-emitting layer of InGaN and a main emission peak at 450 nm. An optoelectronic semiconductor package as shown in FIG. 1 was constructed by mounting the LED chip 2 on a housing 1 in the form of SMD3020 or SMD5050 package (I-Chiun Precision Industry Co., resin section PPA) with a die bonder 5, bonding gold wires 6 to the chip and lead electrodes 3 and 4, dispensing an encapusulating resin composition 7, and curing the resin composition at 150°C for 4 hours.

Oxygen permeability

It is preferred that silicone resin compositions (Sub-compositions #1 and #2) within the scope of the invention have an oxygen permeability of up to 1,000 crn$^3$/m$^2$/24h/atm in the cured state. The oxygen permeability of a sample of 1 mm thick was measured according to JIS K7126-2 at a temperature of 23° C.

Package sulfiding

A 100-ml transparent glass bottle was charged with 0.2 g of sulfur powder and the LED package (encapsulated with each composition) and tightly sealed. The sealed bottle was placed in a dryer at 74°C and taken out after 24 hours. The plated silver portion in the package was observed for color change under a microscope. A sample which turned black was rated "discolored."

Tack

Each silicone composition was evaluated for tack by dispensing the silicone composition to the package, heat curing it, and touching the surface of the package at room temperature (25°C).

Thermal cycling test

A thermal cycling test was performed in a temperature range between -40°C and 125°C over 1,000 cycles. Ten optoelectronic semiconductor packages, prepared as above, were placed in a thermal cycling tester. After 1,000 cycles, the number of LED packages failed (could not be turned on) was counted. The value of 0 in the row of "Number of LEDs failed after thermal cycling" in Table 1 means that all ten packages could be turned on (to emit light) and remained reliable, whereas the value of 10 means that all ten packages were non-operative and less reliable.

Ten optoelectronic semiconductor packages, prepared as above, were measured for total luminous flux by using a total luminous flux measurement system HM-9100 (Otsuka Electronics Co., Ltd.) and conducting current IF = 20 mA. An average of ten measurements was computed. The measured flux value was compared as follows, to determine whether the efficiency of light extraction associated with the addition of a different silicone powder was good or poor.

$$\text{Efficiency of light extraction} = [(\text{total luminous flux after powder addition})/(\text{total luminous flux prior to powder addition})] \times 100 - 100\ (\%)$$

After this measurement, the ten optoelectronic semiconductor packages were held stationary in a dryer at 180°C for 24 hours. They were similarly measured for total luminous flux by using the total luminous flux measurement system HM-9100 and conducting current IF = 20 mA. An average of ten measurements was computed. The measured flux value was compared to determine a total luminous flux retentivity (%) after the heating test, as follows.

$$\text{Total luminous flux retentivity after heating test} = [(\text{total luminous flux after } 180^\circ\text{C}/24 \text{ hr heating})/(\text{initial total luminous flux})] \times 100\ (\%)$$

The total luminous flux retentivity after the heating test was compared to determine whether or not heat resistance was improved by addition of silicone powder.

$$\text{Ratio of total luminous flux retentivity after heating test} = [(\text{total luminous flux retentivity of powder-laden sample after heating test})/(\text{total luminous flux retentivity of non-powder-laden sample after heating test})] \times 100 - 100\ (\%)$$

It is seen from these equations that for both the efficiency of light extraction and the ratio of total luminous flux retentivity, samples giving positive values indicate bright as compared with the reference, and samples giving negative values indicate dark as compared with the reference.

Table 1

| | | Example | | | | | Comparative Example | | | |
|---|---|---|---|---|---|---|---|---|---|---|
| | | 1 | 2 | 3 | 4 | 5 | 1 | 2 | 3 | 4 |
| Composition | | a | b | c | d | e | f | g | h | i |
| Sub-composition No. | | #1 | #1 | #2 | #2 | #4 | #1 | #1 | #3 | #1 |
| Type of silicone powder | | composite | resin | composite | resin | resin | - | resin | - | resin |
| Amount of silicone powder (pbw) | | 10 | 10 | 5 | 5 | 5 | 0 | 10 | 0 | 600 |
| Average particle size of silicone powder (μm) | | 5 | 5 | 0.8 | 0.8 | 0.8 | - | 0.4 | - | 5 |
| Ease of dispensing | | good | good | good | good | good | good | good | good | NG |
| Oxygen permeability of Sub-composition ($cm^3/m^2/24h/atm$) | | 210 | 210 | 400 | 400 | 250 | 210 | 210 | 20000 | 210 |
| Discoloration of plated silver upon sulfur exposure | | no | no | no | no | no | no | no | disclored | no |
| Tack after cure | | no | no | no | no | no | no | no | tacky | no |
| Number of LEDs failed after thermal cycling | 3020 package | 0 | 0 | 0 | 0 | 0 | 10 | 0 | 0 | - |
| | 5050 package | 0 | 0 | 0 | 0 | 0 | 10 | 0 | 0 | - |
| Efficiency of light extraction (%) | 3020 package | 1.0 | 0 | 1.5 | 1.0 | 0 | ±0 (reference) | -36 | - | - |
| | 5050 package | 2.0 | 1.0 | 2.0 | 3.0 | 1.0 | ±0 (reference) | -34 | - | - |
| Ratio of total luminous flux retentivity after heating test | 3020 package | 3.0 | 1.0 | 2.0 | 9.0 | 9.0 | ±0 (referace) | -8,0 | - | - |
| | 5050 package | 2.5 | 1.5 | 1.5 | 5.0 | 13.0 | ±0 (reference) | -5.4 | - | - |

As seen from Table 1, in all Examples 1 to 5, the number of LEDs failed after thermal cycling is 0. That is, crack resistance is good even under thermal cycling between high and low temperatures, no peeling occurs, and the effect of light extraction is satisfactory. Also in the sulfiding test, discoloration is equally prevented as compared with the sample prior to addition of silicone powder. These silicone resins are excellent with respect to the efficiency of light extraction and the total luminous flux retentivity after heating test.

By contrast, the samples of Comparative Example 1 give satisfactory results in the sulfiding test, but failed to emit light after the thermal cycling test because the resin cracked in all packages. It is thus evident that LED packages using prior art encapsulating material are unreliable.

The samples of Comparative Example 2 wherein silicone powder having an average particle size below the range is added give satisfactory results in the sulfiding test and good crack resistance under thermal cycling conditions, but degraded results for both the efficiency of light extraction after addition of silicone powder and the total luminous flux retentivity after heating test. It is thus evident that LED packages using prior art encapsulating material suffer a loss of luminance.

Comparative Example 3 using a resin composition containing a silicone outside the scope of formula (1) as component (A) and having a high oxygen permeability demonstrated that in the sulfiding test, the plated silver turned black in all packages. These results indicate that the use of a resin composition having a high oxygen permeability is not effective for preventing permeation of sulfur oxide gas. It is proven that a composition using a silicone within the scope of formula (1) as component (A) is useful.

The composition of Comparative Example 4 caused nozzle clogging during dispensing and could not be applied to packages in a consistent manner.

It is thus demonstrated that the addition-curable silicone resin composition within the scope of the invention has sufficient thermal shock resistance to ensure crack unsusceptibility and a high efficiency of light extraction, experiences a least discoloration when hot, and maintains luminance or brightness. Thus the composition is advantageous for use with LED packages which are subject to rigorous thermal cycling.

While the invention has been illustrated and described in typical embodiments, it is not intended to be limited to the details shown. Any modified embodiments having substantially the same features and achieving substantially the same results as the technical idea disclosed herein are within the spirit and scope of the invention.

## Claims

1. A curable silicone resin composition for optoelectronic device encapsulation comprising

(A) the following component (A-1):

(A-1) a compound having at least two aliphatic unsaturated radicals per molecule, represented by the formula (1):

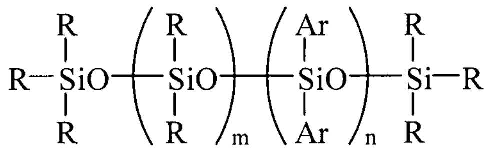

(1)

wherein R is each independently a substituted or unsubstituted monovalent hydrocarbon radical including an aliphatic unsaturated radical, Ar is each independently an aryl radical optionally containing a heteroatom, m is 0 or an integer of at least 1, and n is an integer of at least 1,

(B) an organosilicon compound having at least two silicon-bonded hydrogen atoms per molecule and free of aliphatic unsaturation, in a sufficient amount for the composition to cure in the presence of a hydrosilylation catalyst,
(C) a platinum group metal based hydrosilylation catalyst, and
(D) silicone powder having an average particle size of 0.5 to 100 μm, in an amount of 0.1 to 500 parts by weight per 100 parts by weight of components (A) and (B) combined,

wherein a sub-composition composed essentially of components (A), (B) and (C), when cured, has an oxygen permeability of up to 1,000 cm3/m2/24h/101325 Pa, as measured according to JIS K7126-2 at a temperature of 23°C.

**2.** The composition of claim 1 wherein in formula (1), m is an integer of 0 to 20 and n is an integer of 2 to 10.

**3.** The composition of claim 1 or 2 wherein component (A) further comprises (A-2) an organopolysiloxane of branched or three-dimensional network structure represented by the average compositional formula (2):

$$R'_p(C_6H_5)_qSiO_{(4-p-q)/2} \qquad (2)$$

wherein R' is each independently a substituted or unsubstituted monovalent hydrocarbon radical, alkoxy radical or hydroxyl radical, 0.1 to 80 mol% of all silicon-bonded organic radicals being alkenyl, p and q are positive numbers meeting the range: $1 \leq p+q < 2$ and $0.20 \leq q/(p+q) \leq 0.95$,
wherein the amount of component (A-2) is 20 to 300 parts by weight per 100 parts by weight.

**4.** The composition of any one of claims 1 to 3 wherein a sub-composition composed essentially of components (A), (B) and (C), when cured, has an oxygen permeability of up to 500 $cm^3/m^2/24h/atm$.

**5.** The composition of any one of claims 1 to 4 wherein in formula (1), Ar is phenyl, and n is an integer of 1 to 100.

**6.** The composition of any one of claims 1 to 5 wherein in the organohydrogenpolysiloxane, the number of silicon atoms is 4 to 100 per molecule.

**7.** The composition of claim 1 or 6 wherein component (B) is an organohydrogenpolysiloxane having the average compositional formula (3):

$$R''_aH_bSiO_{(4-a-b)/2} \qquad (3)$$

wherein R" is each independently a silicon-bonded, substituted or unsubstituted monovalent hydrocarbon radical other than an aliphatic unsaturated radical, a and b are positive numbers meeting the range: $0.7 \leq a \leq 2.1$, $0.001 \leq b \leq 1.0$, and $0.8 \leq a+b \leq 3.0$.

**8.** The composition of any one of claims 1 to 7 wherein component (B) is used in such an amount that the molar ratio of SiH radicals in component (B) to aliphatic unsaturated radicals in component (A) ranges from 0.2/1 to 5/1.

**9.** The composition of any one of claims 1 to 8 wherein component (D) consists of particles of a polyorganosilsesquioxane resin or silicone particles covered partially or entirely on their surface with a polyorganosilsesquioxane resin.

**10.** The composition of any one of claims 1 to 9 wherein component (D) is used in an amount of 1 to 100 parts by weight per 100 parts by weight of components (A) and (B) combined.

**11.** An optoelectronic semiconductor device obtained by encapsulating an optoelectronic semiconductor element with the curable silicone resin composition of any one of claims 1 to 10 and heat curing the composition.

**Patentansprüche**

**1.** Härtbare Siliconharzzusammensetzung für die Einkapselung einer optoelektronischen Vorrichtung, umfassend

(A) die folgende Komponente (A-1):

(A-1) eine Verbindung mit mindestens zwei aliphatischen ungesättigten Resten pro Molekül, wiedergegeben durch die Formel (1):

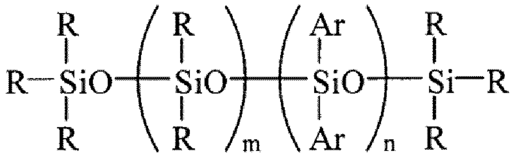

(1)

worin R jeweils unabhängig ein substituierter oder unsubstituierter, einwertiger Kohlenwasserstoffrest einschließlich eines aliphatischen ungesättigten Restes ist, Ar jeweils unabhängig ein Arylrest ist, wahlweise enthaltend ein Heteroatom, m 0 oder eine ganze Zahl von mindestens 1 ist, und n eine ganze Zahl von mindestens 1 ist,

(B) eine Organosiliciumverbindung mit mindestens zwei Silicium-gebundenen Wasserstoffatomen pro Molekül und frei an aliphatischer Ungesättigtheit, in einer ausreichenden Menge zum Härten der Zusammensetzung in Gegenwart eines Hydrosylilierungskatalysators,
(C) ein Hydrosylilierungskatalysator auf Basis eines Platingruppenmetals, und
(D) Siliconpulver mit einer durchschnittlichen Teilchengröße von 0,5 bis 100 $\mu$m in einer Menge von 0,1 bis 500 Gewichtsteilen pro 100 Gewichtsteilen der kombinierten Komponenten (A) und (B),

wobei eine Unterzusammensetzung, zusammengesetzt im Wesentlichen aus Komponenten (A), (B) und (C), wenn sie gehärtet wird, eine Sauerstoffpermeabilität von bis zu 1.000 $cm^3/m^2/24h/101325$ Pa aufweist, gemessen gemäß JIS K7126-2 bei einer Temperatur von 23°C.

2. Zusammensetzung nach Anspruch 1, wobei in der Formel (1) m eine ganze Zahl von 0 bis 20 ist, und n eine ganze Zahl von 2 bis 10 ist.

3. Zusammensetzung nach Anspruch 1 oder 2, wobei Komponente (A) weiterhin (A-2) ein Organopolysiloxan mit verzweigter oder dreidimensionaler Netwerkstruktur umfasst, wiedergegeben durch die durchschnittliche Zusammensetzungsformel (2):

$$R'_p(C_6H_5)_qSiO_{(4-p-q)/2} \qquad (2)$$

worin R' jeweils unabhängig ein subsituierter oder unsubstituierter, einwertiger Kohlenwasserstoffrest, Alkoxyrest oder Hydroxyrest ist, 0,1 bis 80 Mol% sämtlicher Silicium-gebundener organischen Reste Alkenyl sind, p und q positive Zahlen sind, welche innerhalb des Bereichs liegen: $1 \leq p+q < 2$ und $0{,}20 \leq q/(p+q) \leq 0{,}95$,
wobei die Menge an Komponente (A-2) 20 bis 300 Gewichtsteile pro 100 Gewichtsteile beträgt.

4. Zusammensetzung nach mindestens einem der Ansprüche 1 bis 3, wobei eine Unterzusammensetzung, zusammengesetzt im Wesentlichen aus Komponenten (A), (B) und (C), wenn sie gehärtet wird, eine Sauerstoffpermeabilität von bis zu 500 $cm^3/m^2/24h/atm$ aufweist.

5. Zusammensetzung nach mindestens einem der Ansprüche 1 bis 4, wobei in der Formel (1) Ar Phenyl ist, und n eine ganze Zahl von 1 bis 100 ist.

6. Zusammensetzung nach mindestens einem der Ansprüche 1 bis 5, wobei in dem Organohydrogenpolysiloxan die Anzahl an Siliciumatomen 4 bis 100 pro Molekül beträgt.

7. Zusammensetzung nach Anspruch 1 oder 6, wobei Komponente (B) ein Organohydrogenpolysiloxan der durchschnittlichen Zusammensetzungsformel (3) ist:

$$R''_aH_bSiO_{(4-a-b)/2} \qquad (3)$$

worin R" jeweils unabhängig ein Silicium-gebundener, substituierter oder unsubstituierter, einwertiger Kohlenwasserstoffrest ist, der von einem aliphatischen ungesättigten Rest verschieden ist, a und b positive Zahlen sind, welche innerhalb des Bereichs liegen: $0{,}7 \leq a \leq 2{,}1$, $0{,}001 \leq b \leq 1{,}0$ und $0{,}8 \leq a+b \leq 3{,}0$.

8. Zusammensetzung nach mindestens einem der Ansprüche 1 bis 7, wobei Komponente (B) in einer solchen Menge verwendet wird, dass das Molverhältnis an SiH-Resten in Komponente (B) zu aliphatischen ungesättigten Resten in Komponente (A) im Bereich von 0,2/1 bis 5/1 liegt.

9. Zusammensetzung nach mindestens einem der Ansprüche 1 bis 8, wobei Komponente (D) aus Teilchen eines Polyorganosilsesquioxanharzes oder Siliconteilchen, die teilweise oder vollständig auf deren Oberfläche mit einem Polyorganosilsesquioxanharz bedeckt sind, besteht.

10. Zusammensetzung nach mindestens einem der Ansprüche 1 bis 9, wobei Komponente (D) in einer Menge von 1

bis 100 Gewichtsteilen pro 100 Gewichtsteilen der kombinierten Komponenten (A) und (B) verwendet wird.

**11.** Optoelektronische Halbleitervorrichtung, erhalten durch Einkapseln eines optoelektronischen Halbleiterelements mit der härtbaren Siliconharzzusammensetzung gemäß mindestens einem der Ansprüche 1 bis 10 und Wärmehärten der Zusammensetzung.

## Revendications

**1.** Une composition de résine de silicone durcissable pour l'encapsulage d'un dispositif optoélectronique comprenant

(A) le composant (A-1) suivant :

(A-1) un composé ayant au moins deux radicaux aliphatiques non-saturés par molécule, représenté par la formule (1) :

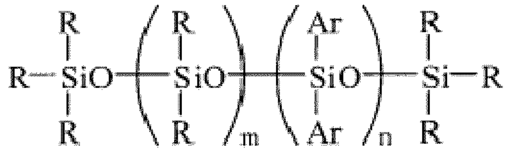

(1)

dans laquelle R est chacun indépendamment un résidu d'hydrocarbure monovalent substitué ou non-substitué comprenant un résidu aliphatique non-saturé, Ar est chacun indépendamment un résidu aryle facultativement comprenant un hétéroatome, m est 0 ou un nombre entier d'au moins 1, et n est un nombre entier d'au moins 1,

(B) un composé d'organosilicium ayant au moins deux atomes d'hydrogène liés à du silicium par molécule et exempt de non-saturation aliphatique, en une quantité suffisante afin que la composition durcisse en la présence d'un catalyseur d'hydrosilylation,
(C) un catalyseur d'hydrosilylation sur base d'un métal du groupe du platine, et
(D) de la poudre de silicium ayant une taille de particule moyenne de 0,5 à 100 $\mu$m, en une quantité de 0,1 à 500 parties en poids par 100 parties en poids des composants (A) et (B) combinés,

dans laquelle une sous-composition composée essentiellement des composants (A), (B) et (C), laquelle, quand durcie, a une perméabilité à l'oxygène de jusqu'à 1000 $cm^3/m^2/24h/101325$ Pa, telle que mesurée selon JIS K7126-2 à une température de 23°C.

**2.** La composition selon la revendication 1, dans laquelle, dans la formule (1), m est un nombre entier de 0 à 20 et n est un nombre entier de 2 à 10.

**3.** La composition selon la revendication 1 ou 2, dans laquelle le composant (A) en plus comprend (A-2) un organopolysiloxane ayant une structure de réseau réticulé ou tridimensionnel représenté par la formule (2) de composition moyenne :

$$R'_p(C_6H_5)_qSiO_{(4-p-q)/2} \qquad (2)$$

dans laquelle R' est chacun indépendamment un résidu d'hydrocarbure monovalent substitué ou non-substitué, un résidu alcoxy ou un résidu hydroxyle, 0,1 à 80% en mole de tous les résidus organiques liés à du silicium étant de l'alcényle, p et q sont des nombres positifs tombant dans la plage : $0.8 \leq p+q < 2$ et $0.8 \leq q/(p+q) \leq 0,95$,
dans laquelle la quantité du composant (A-2) est 20 à 300 parties en poids par 100 parties en poids.

**4.** La composition selon l'une quelconque des revendications 1 à 3, dans laquelle une sous-composition composée essentiellement des composants (A), (B), et (C), laquelle, quand durcie, a une perméabilité à l'oxygène de jusqu'à 500 $cm^3/m^2/24h/atm$.

**5.** La composition selon l'une quelconque des revendications 1 à 4, dans laquelle, dans la formule (1), Ar est phényle,

et n est un nombre entier de 1 à 100.

6. La composition selon l'une quelconque des revendications 1 à 5, dans laquelle, dans l'organohydrogènopolysiloxane, le nombre d'atomes de silicium est 4 à 100 par molécule.

7. La composition selon la revendication 1 ou 6, dans laquelle le composant (B) est un organohydrogènopolysiloxane ayant la formule (3) de composition moyenne :

$$R''_aH_bSiO_{(4-a-b)/2} \qquad (3)$$

dans laquelle R" est chacun indépendamment un résidu d'hydrocarbure monovalent substitué ou non-substitué, lié à du silicium, à part un résidu non-saturé aliphatique, a et b sont des nombres positifs tombant dans la plage : $0.8 \leq a \leq 2,1$, $0.8 \leq b \leq 1,0$, et $0,8 \leq a+b \leq 3,0$.

8. La composition selon l'une quelconque des revendications 1 à 7, dans laquelle le composant (B) est utilisé en une telle quantité, que le rapport molaire de résidus SiH dans le composant (B) aux résidus aliphatiques non-saturés dans le composant (A) se trouve dans la plage de 0,2/1 à 5/1.

9. La composition selon l'une quelconque des revendications 1 à 8, dans laquelle le composant (D) consiste de particules d'une résine de polyorganosilsesquioxane ou particules de silicone partiellement ou entièrement recouvertes sur leurs surfaces avec une résine de polyorganosilsesquioxane.

10. La composition selon l'une quelconque des revendications 1 à 9, dans laquelle le composant (D) est utilisé en une quantité de 1 à 100 parties en poids par 100 parties en poids des composants (A) et (B) combinés.

11. Un dispositif semi-conducteur optoélectronique obtenu par encapsulation d'un élément semi-conducteur optoélectronique avec la composition de résine de silicone durcissable selon l'une quelconque des revendications 1 à 10 et thermodurcissement de la composition.

FIG.1

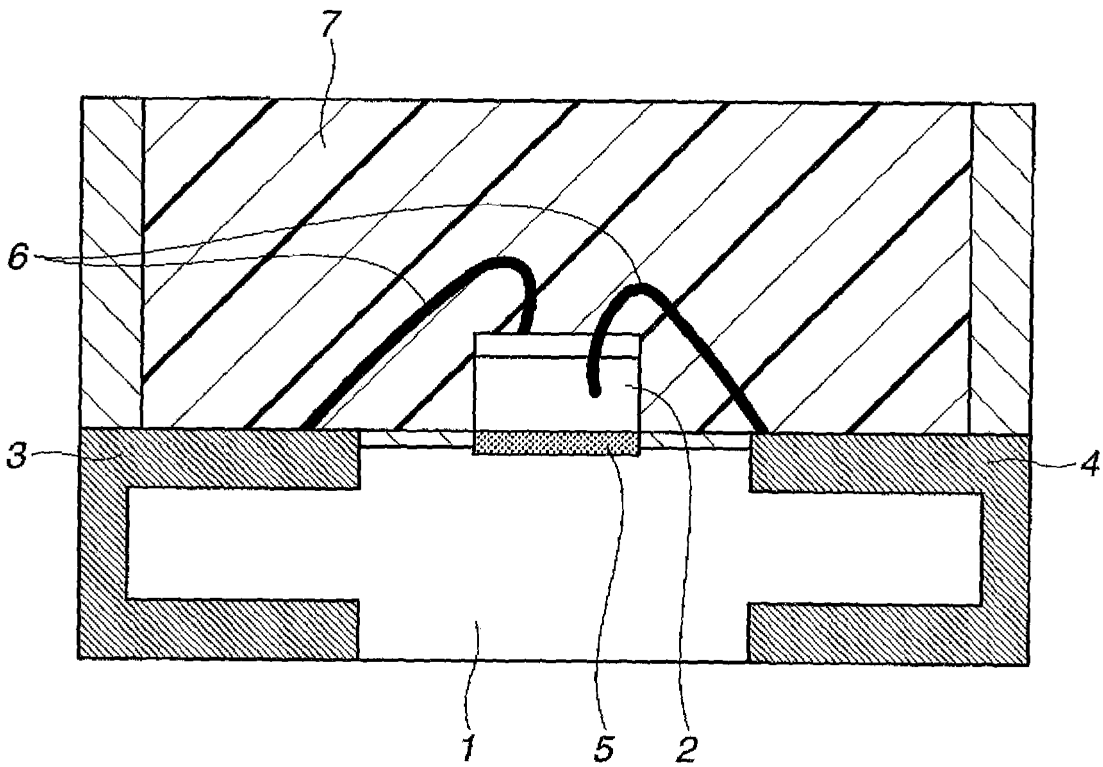

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2011147955 A
- JP 2007077252 A
- JP 2008192880 A
- JP H11001619 A
- JP 2002265787 A
- JP 2004186168 A
- JP 2006321832 A
- JP 2007126609 A
- JP 2008045039 A
- JP 2006339581 A
- JP 2008159713 A
- JP 2011184625 A
- JP S4016917 B
- JP S5472300 A
- JP S6013813 B
- US H03244636 A
- JP H07196815 A